# EUROPÄISCHE PATENTANMELDUNG

(11) **EP 1 796 025 A1**
(43) Veröffentlichungstag der Anmeldung: **13.06.2007**
(21) Anmeldenummer: 06024763.2
(22) Anmeldetag: 30.11.2006
(51) Int. Cl.: G06K 19/077

(54) **Transpondereinrichtung mit Mega-Pads**

(30) Priorität: 09.12.2005 DE 102005058977
(71) Anmelder: ATMEL Germany GmbH, 74072 Heilbronn (DE)
(72) Erfinder: Schropp, Roland, Dipl.-Ing. (FH), 74235 Erlenbach (DE)

(57) **Zusammenfassung**

Transpondereinrichtung (1) mit einer integrierten Schaltungsanordnung (2), einer Spule (5) zur Kopplung an ein elektromagnetisches Feld und wenigstens einem diskreten Kondensator (4), der eine elektrische Verbindung mit der integrierten Schaltungsanordnung (2) und mit der Spule (5) aufweist, wobei die Spule (5) auf Kontaktflächen (6) des Kondensators (4) gebonded ist.

## Beschreibung

Die vorliegende Erfindung betrifft eine Transpondereinrichtung gemäß dem Oberbegriff des Patentanspruchs 1.

Der weitaus größte Teil verkaufter RFID-Systeme arbeitet nach dem Prinzip der induktiven Kopplung.
Ein induktiv gekoppelter Transponder besteht aus einem elektronischen Datenträger, meist einem einzelnen Mikrochip, sowie einer großflächigen Spule oder Leiterschleife, die als Antenne dient.

Induktiv gekoppelte Transponder werden im allgemeinen passiv betrieben. Dies bedeutet, dass die gesamte zum Betrieb des Mikrochips notwendige Energie durch das Lesegerät zur Verfügung gestellt werden muss. Von der Antennenspule des Lesegerätes wird dazu ein starkes hochfrequentes Feld erzeugt, welches den Querschnitt der Spulenfläche und den Raum um die Spule durchdringt.
Ein geringer Teil des ausgesendeten Feldes durchdringt die Antennenspule des Transponders, welcher sich in einiger Entfernung vom Lesegerät befindet. Durch Induktion wird dadurch an der Antennenspule des Transponders die Spannung Ui erzeugt. Diese Spannung wird gleichgerichtet und dient der Energieversorgung des Transponders. Der Antennenspule des Lesegeräts wird ein Kondensator C parallel geschaltet, dessen Kapazität so gewählt wird, dass zusammen mit der Spuleninduktivität der Antennenspule ein Parallelschwingkreis gebildet wird, dessen Resonanzfrequenz der Sendefrequenz des Lesegeräts entspricht.

Auch die Antennenspule des Transponders bildet zusammen mit dem Kondensator C1 einen Schwingkreis, welcher auf die Sendefrequenz des Lesegerätes abgestimmt wird. Durch Resonanzüberhöhung im Parallelschwingkreis erreicht die Spannung U an der Transponderspule ein Maximum.
Denkbar ist auch, dass die Empfangs-/Sendeeinrichtung des Transponders und als Basisstation als serieller Resonanzkreis, d.h. Serienschaltung aus Spule und Kondensator ausgeführt ist.

Bei Transpondereinrichtungen mit magnetischer Kopplung ist die Ausführung der Spule nach wie vor problematisch, da in Abhängigkeit von der Reichweite des Transponders eine bestimmte Spulengröße erforderlich ist. Diese bestimmt somit auch die Baugröße des Transponders mit. Da selbst bei miniaturisierten Transpondern die Anschlussdrähte der Spule immer noch eine gewisse Dicke aufweisen, ist es schwierig, diese an den Halbleiterschaltkreisen zu bonden ohne dabei die Schaltkreise zu beschädigen oder zu zerstören. Weiterhin weist die Spule eine vergleichsweise hohe Masse gegenüber dem Schaltkreis auf, so dass auch eine feste mechanische Verbindung gewährleistet sein muss.

Die EP 0 588 944 B1 offenbart ein Verfahren zur Herstellung einer miniaturisierten Transpondereinrichtung, bei dem die Anschlussdrähte der Antenne direkt mit einer integrierten Schaltungseinrichtung verbunden werden. Dazu sind auf der Schaltungseinrichtung externe vergrößerte Kontaktflächen auf einer zusätzlichen Isolierschicht vorgesehen, die die Schaltungseinrichtung vor zu hoher Wärme und mechanischen Belastungen bei dem Bondvorgang schützen. Im Gegensatz dazu sind die Standardkontaktflächen der Schaltungseinrichtung unterhalb der zusätzlichen Isolierschicht angeordnet. Daher müssen nachträglich wieder Öffnungen in der Isolierschicht hergestellt werden, um eine elektrisch leitende Verbindung zwischen den Standardkontaktflächen und den oberhalb der zusätzlichen Isolierschicht angeordneten externen vergrößerten Kontaktflächen.

Weiterhin offenbart die US 5541399 eine Transpondereinrichtung, bei der die integrierte Schaltungseinrichtung und die Kapazität des Eingangskreises auf einer Trägerplatine, einem so genannten PCB-Board (Printed Circuit Board) angeordnet sind. Hierbei wird die Empfangsspule ebenfalls mit dem PCB-Board verbunden. Nachteilig an dieser Ausführungsart ist, dass die Herstellung der Trägerplatine sehr aufwändig und teuer ist.

Vor diesem Hintergrund besteht die Aufgabe der Erfindung daher darin, eine Transpondereinrichtung vorzusehen, bei der die Spule einfach und kostengünstig verbunden wird.

Diese Aufgabe wird erfindungsgemäß durch eine Vorrichtung der eingangs genannten Art mit den Merkmalen des Patentanspruches 1 gelöst. Günstige Ausgestaltungsformen sind Gegenstand von Unteransprüchen.

Demnach besteht das Wesen der Erfindung darin, dass bei einer Transpondereinrichtung, die eine integrierte Schaltungsanordnung, eine Spule zur Kopplung an ein elektromagnetisches Feld und wenigstens einen diskreten Kondensator umfasst, der eine elektrische Verbindung mit der integrierten Schaltungsanordnung und mit der Spule aufweist, die Spule auf Kontaktflächen des Kondensators gebonded ist. Ein Vorteil der erfindungsgemäßen Transpondereinrichtung ist es, dass einerseits auf eine aufwändige Trägerplatine und andererseits auf zusätzliche Schutzschichten bei der integrierten Schaltungsanordnung verzichtet werden kann.
Unter Bonden wird hierbei das Verbinden zwischen Materialien, Komponenten und/oder Anschlusselementen verstanden. Im allgemeinen wird ein Mikropressschweißverfahren, bei dem gleich- oder verschiedenartige Werkstoffe durch die zeitlich begrenzte Einwirkung von Druck sowie Temperatur und/oder Ultraschall im festen Zustand miteinander verbunden werden, verwendet. Hierbei wird ein Draht oder ein Bändchen mit einer Chipseitigen Anschluss- oder Kontaktfläche verbunden und zu den entsprechenden Kontaktstellen eines anderen Bauelementes geführt und mit diesem ebenfalls verbunden. Je nach der Art der Energiezufuhr wird beim Bonden nach Thermokompressionsverfahren und Ultraschallverfahren unterschieden. Ferner werden auch Lötverfahren angewendet.

Durch die erfindungsgemäße Ausführungsform der Transpondereinrichtung wird der Wärmeeintrag in die integrierte Schaltungsanordnung, der bei den vorgenannten Verfahren zum Bonden oder auch beim Löten entsteht und Schäden an den Halbleiterbauelementen hervorrufen kann, vermieden, da der Kondensator räumlich von der integrierten Schaltungseinrichtung getrennt ist und gegenüber mechanischen und thermischen Einwirkungen eine größere Stabilität aufweist. Beim Bonden der Spulendrähte ist somit ein ausreichender Abstand zu der integrierten Schaltungsanordnung gesichert.
Hinzu kommt, dass die Flexibilität bei der Transponderherstellung erhöht werden kann, da je nach Anforderung an den Schwingkreis, bei gleicher integrierter Schaltungsanordnung ein Kondensator mit höherer oder niedrigerer Kapazität gewählt werden kann, während bei einem in der integrierten Schaltungsanordnung eingebundenen Kondensator der Kapazitätswechsel nach dem Herstellungsprozess der Schaltungsanordnung sehr aufwändig und teuer ist.

Gemäß einer Weiterbildung der Erfindung besteht der Kondensator wiederum aus wenigstens zwei miteinander verschalteten Kondensatoren. Je nach Anforderungen an den Schwingkreis des Transponders können somit mehrere Kondensatoren parallel oder in Reihe geschaltet werden. Dadurch können, ohne dass Änderungen bei den integrierten Schaltungsanordnungen oder Halbleiterelementen vorgenommen werden müssten, unterschiedliche Ausführungsformen erstellt werden.

Eine andere Weiterbildung sieht vor, dass bei der Transpondereinrichtung wenigstens ein Kondensator als einzelnes Halbleiterbauelement vorgesehen ist. Hierbei wird während des Herstellungsprozesses der integrierten Schaltung benachbart auf dem Wafer ein Kondensator hergestellt. Denkbar ist auch, um die Herstellungskosten zu senken, den Kondensator mittels eines separaten speziell auf die Herstellung von Kondensatoren angepassten Technologieprozesses zu fertigen.

Vorteilhafterweise sind an dem Kondensator unterschiedliche Kontaktflächen für die elektrische Verbindung zu der integrierten Schaltungsanordnung und der Spule vorgesehen. Hierbei sind die Kontaktflächen jeweils der Größe der anzuschließenden Verbindungsdrähte und Bonddrähte angepasst. Aus der Größe der Spulendrähte ergibt sich daher, dass die Kontaktflächen zur Kontaktierung der Spule wesentlich größer als die zur Kontaktierung bzw. zum Bonden der integrierten Schaltungsanordnung vorgesehen sind.

Gemäß einer weiteren Ausführungsform der Erfindung sind die integrierte Schaltungsanordnung, die Spule und der Kondensator auf einer Trägerfolie angeordnet. Diese Ausführungsform hat den Vorteil dass die Transponderhalbzeuge fixiert werden und der Platzbedarf dabei aber so gering wie möglich gehalten werden kann.

Eine andere Ausführungsart sieht vor, dass eine Laminierung für die integrierte Schaltungsanordnung, die Spule und den Kondensator vorgesehen ist. Hierbei ist zusätzlich zu einer Trägerfolie für das Transponderhalbzeug eine Deckfolie vorgesehen und mit dieser passgenau fixiert. Anschließend werden die Folien in einer Laminieranlage unter Zuführung von Wärme und bei hohem Druck in einen weichelastischen Zustand gebracht und verbacken dabei zu einem unlösbaren Verbund.

Eine weitere vorteilhafte Ausführungsform sieht vor, dass die integrierte Schaltungsanordnung, die Spule und der Kondensator von einer Vergussmasse umgeben sind. Dadurch kann die Stabilität der spröden und bruchempfindlichen Halbleiterbauelemente erheblich erhöht werden.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Anhand der Figuren soll die Erfindung näher beschrieben werden. Dabei zeigt
- Fig. 1: eine Draufsicht auf eine Transpondereinrichtung
- Fig. 2: eine Seitenansicht der Transpondereinrichtung aus Fig. 1

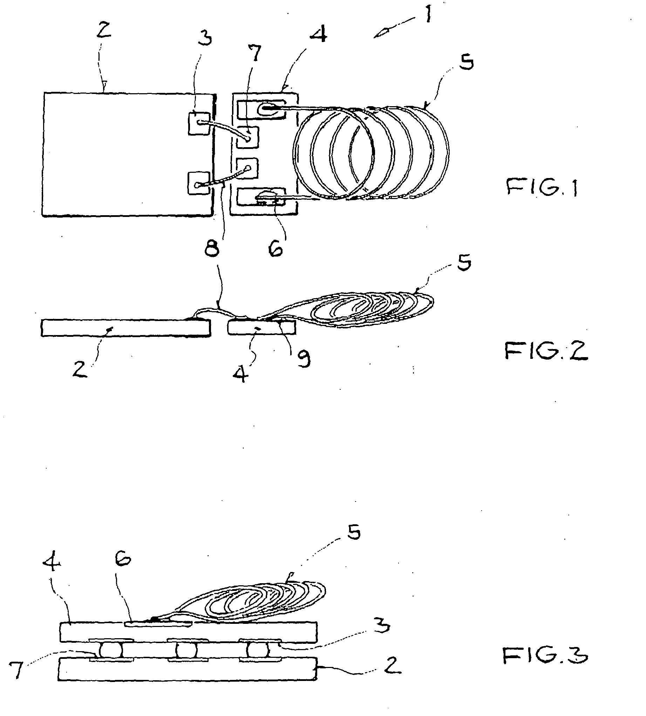

In Fig. 1 wird eine erfindungsgemäße Transpondereinrichtung 1 mit einer integrierten Schaltungsanordnung 2 und einer Spule 5 zur Kopplung an ein magnetisches Feld dargestellt. Zwischen Spule 5 und integrierter Schaltungsanordnung 2 ist ein Kondensator 4 angeordnet, der mit der Spule 5 zusammen einen Empfangsschwingkreis bildet. Der Kondensator 4 ist jeweils mit der Spule 5 und der integrierten Schaltungseinrichtung 2 über Bonddrähte verbunden. Dabei sind die Kontaktflächen 6 auf dem Kondensator und die Kontaktflächen 3 auf der integrierten Schaltungsanordnung 2 in einer Größe vorgesehen, die zur Verbindung der Bauteile mit den Bonddrähten 8 üblich ist.
Im Gegensatz dazu weisen die Kontaktflächen zur elektrischen Verbindung der Spule 5 weitaus größere Kontaktflächen auf, die dem Durchmesser des Drahtes der Spule 5 entsprechen.
Wie aus Fig. 2 ersichtlich ist, ist für die elektrische Verbindung zur Spule 5 jeweils ein Kontakthöcker 9 aus Gold vorgesehen, der gewährleistet, dass eine sichere Verbindung der Drähte 5 mittels Thermo-Kompressionsverfahren erreicht wird. Hierbei wird durch Einbringen von relativ geringer Wärme und Kraft eine sichere Verbindung zwischen dem Löthöcker 9 und der Kontaktfläche 6 erzeugt.

Es ist jedoch auch vorstellbar, die Spulendrähte auch auf Kontaktflächen ohne Kontakthöcker zu bonden.
Ferner lässt sich auch vorstellen, dass die Kondensatoren mittels einer Flip-Chip Technik mit der integrierten Schaltungseinrichtung verbunden werden und ausschließlich die Spulendrähte auf Kontaktflächen verbunden werden.
Weiterhin ist vorstellbar, dass die Kontaktflächen auf dem Kondensator für die Spule und die integrierte Schaltungseinrichtung auf gegenüberliegenden Seiten d.h. Ober- und Unterseite des Kondensators angeordnet sind. Insbesondere bei einem stapelförmigen Aufbau ist dies sehr vorteilhaft.

### Bezugszeichenliste

- 1: Transpondereinrichtung
- 2: Integrierte Schaltungsanordnung
- 3: Kontaktfläche
- 4: Kondensator
- 5: Spule
- 6: Kontaktfläche für Spule
- 7: Kontaktfläche für integrierte Schaltungsanordnung
- 8: Bondingdrähte
- 9: Kontakthöcker

## Patentansprüche

1. Transpondereinrichtung (1), umfassend
• eine integrierte Schaltungsanordnung (2),
• eine Spule (5) zur Kopplung an ein elektromagnetisches Feld, und
• wenigstens einen diskreten Kondensator (4), der eine elektrische Verbindung mit der integrierten Schaltungsanordnung (2) und mit der Spule (5) aufweist,
**dadurch gekennzeichnet, dass** die Spule (5) auf Kontaktflächen (6) des Kondensators (4) gebonded ist.

2. Transpondereinrichtung (1) gemäß Anspruch 1, **dadurch gekennzeichnet, dass** der Kondensator (4) aus wenigstens zwei miteinander verschalteten Kondensatoren besteht.

3. Transpondereinrichtung (1) gemäß Anspruch 1 oder 2, **dadurch gekennzeichnet, dass** wenigstens ein Kondensator (4) als einzelnes Halbleiterbauelement vorgesehen ist.

4. Transpondereinrichtung (1) gemäß einem der Ansprüche 1 bis 3, **dadurch gekennzeichnet, dass** an dem Kondensator (4) Kontaktflächen (6, 7) für die elektrische Verbindung zu der integrierten Schaltungsanordnung (2) und der Spule (5) vorgesehen sind, die jeweils der Größe der anzuschließenden Verbindungsdrähte (5, 8) angepasst sind.

5. Transpondereinrichtung (1) gemäß Anspruch 4, **dadurch gekennzeichnet, dass** die Kontaktflächen (6) zur Kontaktierung der Spule (5) wesentlich größer als die Kontaktflächen (7) zur Kontaktierung der integrierten Schaltungsanordnung (2) vorgesehen sind.

6. Transpondereinrichtung (1) gemäß Anspruch 4 oder 5, **dadurch gekennzeichnet, dass** die Kontaktflächen (6) zur Kontaktierung der Spule (5) und die Kontaktflächen zur Kontaktierung der integrierten Schaltungsanordnung (2) auf gegenüberliegenden Seiten des Kondensators (4) vorgesehen sind.

7. Transpondereinrichtung (1) gemäß Anspruch 6, **dadurch gekennzeichnet, dass** die integrierte Schaltungseinrichtung (2) und der Kondensator (4) stapelförmig aufgebaut sind.

8. Transpondereinrichtung (1) gemäß einem der Ansprüche 1 bis 5, **dadurch gekennzeichnet, dass** die integrierte Schaltungsanordnung (2), die Spule (5) und der Kondensator (4) auf einer Trägerfolie angeordnet sind.

9. Transpondereinrichtung (1) gemäß einem der Ansprüche 1 bis 7, **dadurch gekennzeichnet, dass** eine Laminierung für die integrierte Schaltungsanordnung (2), die Spule (5) und den Kondensator (4) vorgesehen ist.

10. Transpondereinrichtung (1) gemäß einem der Ansprüche 1 bis 7, **dadurch gekennzeichnet, dass** die integrierte Schaltungsanordnung (2), die Spule (5) und der Kondensator (4) von einer Vergussmasse umgeben sind.
